# EUROPEAN PATENT APPLICATION

(11) **EP 4 563 719 A1**
(43) Date of publication of application: **04.06.2025**
(21) Application number: 23902551.3
(22) Date of filing: 06.12.2023
(51) Int. Cl.: C23C 16/455

(54) **SPRAY PLATE, SPRAY METHOD, AND PROCESSING DEVICE**

(30) Priority: 15.12.2022 CN 202211612666
(71) Applicant: Jiangsu Leadmicro Nano-Technology Co., Ltd., Wuxi, Jiangsu 214000 (CN)
(72) Inventor: KANG, Xu, Wuxi, Jiangsu 214000 (CN); YAN, Da, Wuxi, Jiangsu 214000 (CN); SHI, Shupeng, Wuxi, Jiangsu 214000 (CN)
(74) Representative: van Breda, Jacobus
(86) International application number: PCT/CN2023/136680
(87) International publication number: WO 2024/125354

(57) **Abstract**

A spray plate (100), a processing device (10), and a spray method. The spray plate (100) comprises a plate body (110), wherein a gas distribution system (120) is formed in the plate body; and the gas distribution system (120) comprises a main gas inlet channel (121), a transition channel (122) and a spray channel (123). A process gas firstly enters the plate body (110) from the main gas inlet channel (121), then enters the spray channel (123) after being transferred by means of the transition channel (122), and is finally guided into a processing chamber (100) from a gas outlet surface (111) by means of a spray hole (1231). The transition channel (122) can achieve a buffering effect, thereby preventing gas pressure in the spray channel (123) from being directly affected by the fluctuation of gas pressure in the main gas inlet channel (121), and thus maintaining good consistency of the gas pressure in the spray channel (123). Therefore, after being transferred by means of the transition channel (122), a gas flow sprayed from each area of the gas outlet surface (111) is more balanced, thereby improving the distribution uniformity of the process gas in the processing chamber (100).

## Description

The present application claims the priority to Chinese Patent Application No. 202211612666.3, titled "SPRAY PLATE, SPRAY METHOD, AND PROCESSING DEVICE", filed with the China National Intellectual Property Administration on December 15, 2022, the entire disclosure of which is incorporated herein by reference.

### FIELD

The present application relates to the technical field of vacuum coating, and in particular to a spray plate, a spray method, and a processing device.

### BACKGROUND

During industrial production processes, a specific process gas usually needs to be sprayed into a processing chamber through a spray plate to promote a corresponding reaction for a specific purpose of production. For example, atomic layer deposition (ALD) technology is a thin film deposition technology based on a surface chemical vapor reaction. With this technology, a surface of a substrate is coated with a material in the form of a monoatomic layer film, and the thickness and uniformity of the deposited thin film can be precisely controlled within the range of thickness of the atomic layers. Due to its advantages, the atomic layer deposition technology has been widely applied to semiconductors, photovoltaic cells and other fields. During a coating operation of an atomic layer deposition coating device, the process gas needs to be introduced into a reaction chamber by the spray plate firstly for a coating reaction.

Because of structural limitations, the flow rate of the gas is significantly different in different areas of the conventional spray plate, causing relatively poor distribution uniformity of the process gas introduced into the processing chamber. For the atomic layer deposition coating process, nonuniform distribution of the process gas may lead to poor uniformity of the thickness of the coating film.

### SUMMARY

Thus, in view of the above problem, it is necessary to provide a spray plate, a spray method, and a processing device that can improve the distribution uniformity of a process gas inside a processing chamber.

A spray plate includes a plate body that has a gas outlet face. A gas distribution system is formed in the plate body, and the gas distribution system includes a main gas inlet channel, a transition channel and a spray channel. A plurality of spray holes are formed in the spray channel in an extension direction of the spray channel and extend to the gas outlet face, and the spray channel is in communication with the main gas inlet channel through the transition channel.

In an embodiment, the numbers of the transition channel and the spray channel are both plural, and the plurality of transition channels are in one-to-one correspondence with the plurality of spray channels. Each of the plurality of spray channels is in communication with a corresponding one of the plurality of transition channels through a plurality of connecting channels that are distributed at intervals in the extension direction of the spray channel. The main gas inlet channel is in communication with the plurality of transition channels in sequence.

In an embodiment, each of the plurality of spray channels is of an elongated shape and extends along a first direction, and the plurality of spray channels are arranged at intervals in a second direction perpendicular to the first direction.

In an embodiment, each of the plurality of transition channels is of an elongated shape and extends along the first direction, and each of the plurality of transition channels is spaced apart from a corresponding one of the plurality of spray channels in a third direction perpendicular to both of the first direction and the second direction.

In an embodiment, the main gas inlet channel is of an elongated shape and extends along the second direction.

In an embodiment, the main gas inlet channel is in communication with middle portions of the plurality of transition channels in sequence.

In an embodiment, a junction of the main gas inlet channel and each of the plurality of transition channels is offset from a midpoint of the transition channel towards an end of the transition channel.

In an embodiment, a part of the transition channel located on one side of the junction opposite to the midpoint has a smaller inner diameter than a part of the transition channel located on the other side of the junction facing the midpoint.

In an embodiment, a junction of the main gas inlet channel and each of the plurality of transition channels is at a midpoint of the transition channel.

In an embodiment, the numbers of the connecting channels on two sides of the junction in the first direction are the same.

In an embodiment, each of two ends of the main gas inlet channel in an extension direction of the main gas inlet channel is provided with a gas inlet.

In an embodiment, the main gas inlet channel includes an introducing channel, a splitting channel that extends along the first direction, and two discharging channels that extend along the second direction.

The introducing channel is in communication with a middle portion of the splitting channel, and the two discharging channels are in communication with two ends of the splitting channel respectively.

One of the two discharging channels is in communication with one end of each of the plurality of transition channels in sequence, and the other one of the two discharging channels is in communication with the other end of each of the plurality of transition channels in sequence.

In an embodiment, a junction of the introducing channel and the splitting channel is offset from a midpoint of the splitting channel towards an end of the splitting channel.

In an embodiment, a part of the splitting channel located on one side of the junction opposite to the midpoint has a smaller inner diameter than a part of the splitting channel located on the other side of the junction facing the midpoint.

In an embodiment, a junction of the introducing channel and the splitting channel is at a midpoint of the splitting channel.

In an embodiment, the numbers of the introducing channel and the splitting channel are both two.

The two splitting channels are respectively arranged at two ends of the plate body in the second direction.

One end of one of the two introducing channels and one end of the other one of the two introducing channels are in communication with two ends of one of the two splitting channels respectively, and the other end of the one of the two introducing channels and the other end of the other one of the two introducing channels are in communication with two ends of the other one of the two splitting channels respectively.

In an embodiment, the number of the gas distribution systems provided in the plate body is at least two, and the plurality of spray channels of the at least two gas distribution systems are alternately arranged in the second direction.

A spray plate includes a plate body that has a gas outlet face.

A gas distribution system is formed in the plate body, and the gas distribution system includes a main gas inlet channel, a transition channel and a spray channel.

The spray channel is in communication with a plurality of spray holes that are arranged at intervals in an extension direction of the spray channel.

Each of the plurality of spray holes extends to the gas outlet face, and the spray channel is in communication with the main gas inlet channel through the transition channel.

In an embodiment, the numbers of the transition channels and the spray channels are both plural, and the plurality of transition channels are in one-to-one correspondence with the plurality of spray channels.

Each of the plurality of spray channels is in communication with a corresponding one of the plurality of transition channels through a plurality of connecting channels that are distributed at intervals in the extension direction of the spray channel.

The main gas inlet channel is in communication with the plurality of transition channels in sequence.

In an embodiment, each of the plurality of spray channels is of an elongated shape and extends along a first direction. The plurality of spray channels are arranged at intervals in a second direction, and an angle is present between the first direction and the second direction.

In an embodiment, each of the plurality of transition channels is of an elongated shape and extends along the first direction, and each of the plurality of transition channels is spaced apart from a corresponding one of the plurality of spray channels in a third direction. Angles are present respectively between the third direction and the first direction, and between the third direction and the second direction.

In an embodiment, the main gas inlet channel is of an elongated shape and extends along the second direction.

In an embodiment, a junction of the main gas inlet channel and each of the plurality of transition channels is offset from a midpoint of the transition channel towards an end of the transition channel.

In an embodiment, the transition channel includes a first channel portion and a second channel portion respectively located on two sides of the junction.

A length of the first channel portion is smaller than a length of the second channel portion, and an inner diameter of the first channel portion is smaller than an inner diameter of the second channel portion.

In an embodiment, a junction of the main gas inlet channel and each of the plurality of transition channels is at a midpoint of the transition channel.

In an embodiment, the numbers of the connecting channels on two sides of the junction of the transition channel in the first direction are the same.

In an embodiment, each of two ends of the main gas inlet channel in an extension direction of the main gas inlet channel is provided with a gas inlet.

In an embodiment, the main gas inlet channel includes an introducing channel, a splitting channel that extends along the first direction, and two discharging channels that extend along the second direction.

The introducing channel is in communication with the splitting channel, and the two discharging channels are in communication with two ends of the splitting channel respectively.

One of the two discharging channels is in communication with one end of each of the plurality of transition channels in sequence, and the other one of the two discharging channels is in communication with the other end of each of the plurality of transition channels in sequence.

In an embodiment, a junction of the introducing channel and the splitting channel is offset from a midpoint of the splitting channel towards an end of the splitting channel.

In an embodiment, the splitting channel includes a third channel portion and a fourth channel portion respectively located on two sides of the junction.

A length of the third channel portion is smaller than a length of the fourth channel portion, and an inner diameter of the third channel portion is smaller than an inner diameter of the fourth channel portion.

In an embodiment, a junction of the introducing channel and the splitting channel is at a midpoint of the splitting channel.

In an embodiment, the numbers of the discharging channel and the splitting channel are both two.

The two splitting channels are respectively arranged at two ends of the plate body in the second direction.

One end of one of the two introducing channels and one end of the other one of the two introducing channels are in communication with two ends of one of the two splitting channels respectively, and the other end of the one of the two introducing channels and the other end of the other one of the two introducing channels are in communication with two ends of the other one of the two splitting channels respectively.

In an embodiment, the number of the gas distribution systems provided in the plate body is at least two, and the plurality of spray channels of the at least two gas distribution systems are alternately arranged in the second direction.

A processing device includes the spray plate according to any one of the above preferred embodiments and a processing chamber. The spray plate is mounted on the processing chamber, and the gas outlet face faces an inner side of the processing chamber.

According to the spray plate and the processing device described above, the process gas enters an interior of the plate body through the main gas inlet channel firstly, then enters the spray channel after being conveyed through the transition channel, and finally is introduced into the processing chamber from the gas outlet face through the spray holes. The transition channels can serve as a buffer to prevent a gas pressure inside the spray channel from being directly affected by fluctuation of a gas pressure inside the main gas inlet channel, so that the gas pressure inside the spray channel can keep good uniformity. Therefore, after being conveyed through the transition channel, the flow quantity of the gas being sprayed from each region of the gas outlet face is more even, so that the process gas is distributed inside the processing chamber more uniformly.

A spray method includes the following steps:
introducing a process gas into a transition channel through a main gas inlet channel;
introducing the process gas through the transition channel into a spray channel in communication with the transition channel; and
conveying the process gas, which enters the spray channel, along the spray channel, and spraying the process gas into a processing chamber through a plurality of spray holes distributed in an extension direction of the spray channel.

According to the spray method described above, the process gas is introduced into the transition channel through the main gas inlet channel firstly, and enters the spray channel after being conveyed through the transition channel. The transition channels can serve as a buffer to prevent the gas pressure inside the spray channel from being directly affected by fluctuation of the gas pressure inside the main gas inlet channel, so that the gas pressure inside the spray channel can keep good uniformity. Therefore, after being conveyed through the transition channel, the flow quantity of the gas being sprayed from the spray holes is more even, so that the process gas is distributed inside the processing chamber more uniformly.

### BRIEF DESCRIPTION OF THE DRAWINGS

For more clearly illustrating embodiments of the present application or the technical solutions in the conventional technology, drawings referred to describe the embodiments or the conventional technology will be briefly described hereinafter. Apparently, the drawings in the following description are only some examples of the present application, and for those skilled in the art, other drawings may be obtained based on these drawings without any creative efforts.
FIG. 1 is a schematic view showing a part of the structure of a processing device according to an embodiment of the present application;
FIG. 2 is a front perspective view of a spray plate of the processing device shown in FIG. 1;
FIG. 3 is a schematic view of a gas distribution system in the spray plate shown in FIG. 2;
FIG. 4 is a front perspective view of a spray plate according to another embodiment of the present application;
FIG. 5 is a schematic view of a gas distribution system in the spray plate shown in FIG. 4; and
FIG. 6 is a schematic flowchart of a spray method according to an embodiment of the present application.

### DETAILED DESCRIPTION OF THE EMBODIMENTS

Specific embodiments of the present application will be described in detail as follows in conjunction with the accompany drawings, so that purposes, characteristics and advantages of the present application can be more obvious and understandable. In the following description, many details are illustrated for a full understanding of the present application. However, the present application can be implemented in many other ways different from those described herein, and similar improvements may be made by those skilled in the art without violating the concept of the present application. Therefore, the present application is not limited by the specific embodiments disclosed hereinafter.

In the description of the present application, it should be noted that the orientation or positional relationships indicated by terms such as "center", "longitudinal", "lateral", "length", "width", "thickness", "up", "down", "front", "back", "left", "right", "vertical", "horizontal", "top", "bottom", "inner", "outer", "clockwise", "counterclockwise", "axial", "radial", "circumferential" and the like are based on the orientation or positional relationships shown in the drawings, and are merely for the convenience of describing the present application and the simplification of the description, and do not indicate or imply that the device or element referred to must have a particular orientation, or be configured and operated in a particular orientation, which therefore should not be construed as a limitation to the present application.

Moreover, terms such as "first", "second" and the like are merely for description, and should not be construed as indicating or implying relative importance, or implicitly indicate the number of technical features being referred to. In this way, the feature defined by the terms "first", "second" may explicitly or implicitly include at least one such features. In the description of this application, the term "a plurality of" means at least two, such as two, three, etc., unless otherwise clearly and specifically defined.

In this application, unless otherwise clearly specified and limited, the terms "mounted on", "connected to", "connected with", "fixed to" and the like should be construed broadly. For example, the connection may be a fixed connection, a detachable connection, or an integral connection, or may be a mechanical connection or an electrical connection, or may be a direct connection or an indirect connection through an intermediate medium, or may be communication between interiors of two elements or an interaction relationship between two elements, unless otherwise clearly defined. For those skilled in the art, the specific meanings of the above terms in the present application may be understood according to specific situations.

In the present application, unless otherwise clearly specified and limited, if a first feature is "above" or "below" a second feature, the first feature and the second feature may directly contact each other or indirectly contact through an intermediate medium. Furthermore, if the first feature is "on", "on top of", and "above" the second feature, the first feature may be exactly on or obliquely above the second feature, or the first feature is higher in level than the second feature. If the first feature is "under", "at the bottom of", and "below" the second feature, the first feature may be exactly on or obliquely below the second feature, or the first feature is lower in level than the second feature.

It should be noted that, when an element is said to be "fixed on" or "provided on" another element, it may be directly on the another element, or there may be an intermediate element. When an element is said to be "connected to" another element, it may be directly connected to the another element, or there may be an intermediate element at the same time. The terms "vertical", "horizontal", "up", "down", "left", "right" and similar expressions used herein are merely for illustrative purposes, and do not indicate the only way to implement the present application.

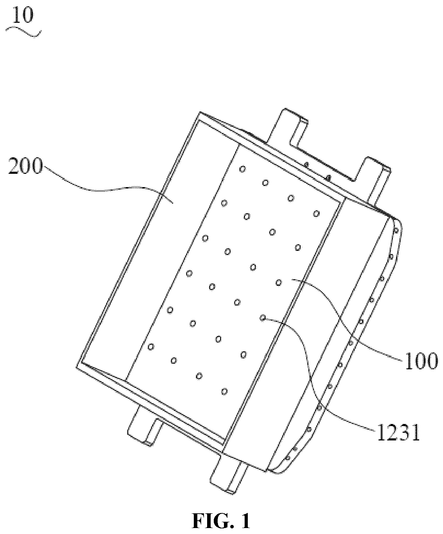

Referring to FIG. 1, a processing device 10 and a spray plate 100 are provided according to the present application. The processing device 10 includes the spray plate 100 and a processing chamber 200.

A vacuum can be created inside the processing chamber 200, and the spray plate 100 has a gas outlet face 111. The spray plate 100 is mounted on the processing chamber 200, and the gas outlet face 111 faces an inner side of the processing chamber 200. A process gas can be introduced into the spray plate 100, and be then sprayed into the processing chamber 200 through a spray hole 1231 in the gas outlet face 111, so that a reaction occurs inside the processing chamber 200. For example, a surface of a silicon wafer is coated with an aluminum oxide film.

Specifically, in the present embodiment, the processing device 10 is an atomic layer deposition coating device, and thus a coating reaction occurs after the process gas enters the processing chamber 200. Apparently, the processing device 10 may be applied to other fields.

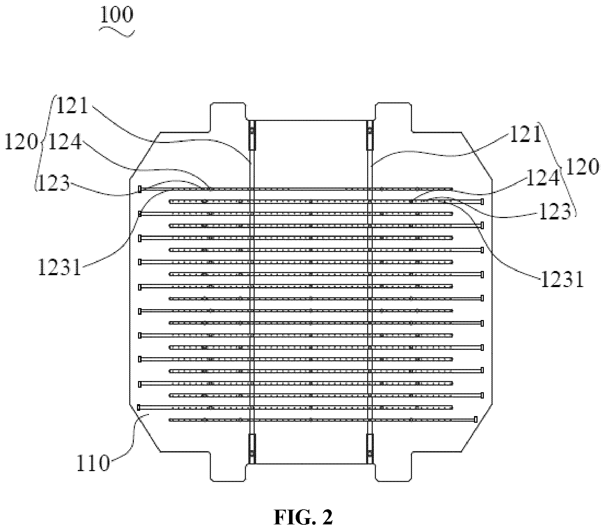

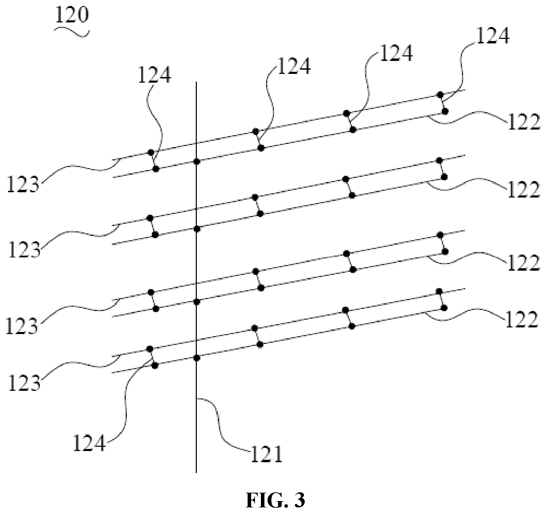

Referring to FIGS. 2 and 3, the spray plate 100 according to an embodiment of the present application includes a plate body 110 and a gas distribution system 120.

The plate body 110 is generally formed of a metal material, and an outer outline of the plate body 110 matches with an outline of the processing chamber 200. The gas outlet face 111 is formed on a side of the plate body 110. The gas distribution system 120 is configured to introduce and distribute the process gas, and finally spray the process gas into the processing chamber 200 through the spray hole 1231. The number of the gas distribution system 120 is at least two (generally two), since at least two kinds of process gases are needed during coating. The at least two gas distribution systems 120 are independent of each other, and have the same structure.

Each gas distribution system 120 includes a main gas inlet channel 121, a transition channel 122, and a spray channel 123.

The plate body 110 may be of an integrally formed structure, and a flow channel structure of the gas distribution system 120 may be processed in the plate body 110 by drilling. Alternatively, the plate body 110 may be formed of two parts both provided with grooves, which may be combined to form the flow channel structure of the gas distribution system 120.

The main gas inlet channel 121 is provided with a gas inlet, which may be in communication with a gas source to introduce the process gas. The spray channel 123 is evenly distributed in the plate body 110. Multiple spray holes 1231 are formed on the spray channel 123 in an extension direction of the spray channel 123 and extend to the gas outlet face 111. That is, the spray channel 123 is in communication with multiple spray holes 1231 that are spaced apart in the extension direction of the spray channel 123, and each of the spray holes 123 extends to the gas outlet face 111. The spray channel 123 is in communication with the main gas inlet channel 121 through the transition channel 122. Therefore, the process gas being introduced into the plate body 110 through the main gas inlet channel 121 is conveyed through the transition channel 122, then enters the spray channel 123, and finally is sprayed into the processing chamber 200 through the spray holes 1231. The transition channel 122 can serve as a buffer to prevent a gas pressure inside the spray channel 123 from being directly affected by fluctuation of a gas pressure inside the main gas inlet channel 121, so that the gas pressure inside the spray channel 123 can keep good uniformity. Hence, the process gas sprayed from various regions of the gas outlet face 111 has a relatively uniform flow speed, and the quantity of the gas flow is more even, which enhances the distribution uniformity of the process gas inside the processing chamber 200, thereby improving the uniformity of the thickness of the coating film.

Specifically, in the present embodiment, multiple transition channels 122 and multiple spray channels 123 are provided, and the multiple transition channels 122 are in one-to-one correspondence with the multiple spray channels 123. Each of the multiple spray channels 123 is in communication with a corresponding one of the multiple transition channels 122 through multiple connecting channels 124 that are spaced apart in the extension direction of the spray channel 123. The main gas inlet channel 121 is in communication with the multiple transition channels 122 in sequence.

For example, if ten transition channels 122 are provided, then ten spray channels 123 are provided. The multiple connecting channels 124 between each spray channel 123 and the corresponding transition channel 122 may be evenly or unevenly spaced apart, and the number of connecting channels 124 may be three, four, five, etc. according to actual needs. With the multiple spray channels 123, the process gas can be sprayed more evenly. The multiple transition channels 122 are used for transition conveying of the process gas individually, so as to ensure similar flow rate of the process gas in each spray channel 123. Moreover, with the multiple connecting channels 124, the process gas inside each transition channel 122 can enter the corresponding spray channel 123 from different multiple positions at the same time, so that the process gas inside the spray channel 123 is more evenly distributed.

Each spray channel 123 may be of an elongated shape, an arc shape, a wave shape or other shapes. Considering the complexity of the forming process, the spray channel 123 in the present embodiment is of an elongated shape and extends along a first direction. The first direction refers to a left-right direction shown in FIG. 2, i.e. a width direction of the plate body 110. Moreover, the multiple spray channels 123 are arranged at intervals in a second direction perpendicular to the first direction. The second direction refers to an up-down direction shown in FIG. 2, i.e. a length direction of the plate body 110. It should be understood that, the second direction may not be perpendicular to the first direction, that is, the second direction may be at an angle other than 90 degrees from the first direction, which is also feasible. A distance between every two adjacent spray channels 123 is basically constant. By arranging the multiple spray channels 123 at intervals in the second direction, they can be evenly distributed in the plate body 110.

In the present embodiment, each transition channel 122 is of an elongated shape and extends along the first direction, and each transition channel 122 is spaced apart from the corresponding spray channel 123 in a third direction perpendicular to both of the first direction and the second direction. The third direction refers to a direction perpendicular to the plane of the paper shown in FIG. 2, i.e. a thickness direction of the plate body 110. It should be understood that, the third direction may not be perpendicular to the first direction or the second direction, that is, the third direction may be at an angle other than 90 degrees from the first direction or the second direction, which is also feasible.

With such arrangement, a space in the plate body 110 along the first direction (for example, the thickness direction) can be appropriately utilized, so as to facilitate the arrangement of the at least two gas distribution systems 120 in the plate body 110. Moreover, since the transition channel 122 is parallel to the corresponding spray channel 123, a distance between the transition channel 122 and the corresponding spray channel 123 keeps constant along the extension direction of the transition channel 122 and the corresponding spray channel 123. Thus, the process gas inside the transition channel 122 can enter the corresponding spray channel 123 more uniformly during transition conveying of the process gas.

Referring to FIG. 2 again, in the present embodiment, the spray channels 123 of the at least two gas distribution systems 120 are alternately arranged in the second direction. Specifically, one of the spray channels of one gas distribution system 120 is provided between two corresponding adjacent spray channels 123 of another gas distribution system 120. As such, the at least two kinds of process gases can be uniformly distributed and fully react inside the processing chamber 200, which is beneficial to improving the distribution uniformity of the process gases inside the processing chamber 200.

Referring to FIG. 3 again, in the present embodiment, the main gas inlet channel 121 is of an elongated shape and extends along the second direction. As such, a flow path of the process gas from the main gas inlet channel 121 to each transition channel 122 is relatively short, which helps the process gas reach the transition channel 122 quickly, and reduces the difference between flow rates of the process gas entering the various transition channels 122 caused by a relatively long flow path.

In the present embodiment, the main gas inlet channel 121 is in communication with middle portions of the multiple transition channels 122 in sequence. After entering each transition channel 122 from the main gas inlet channel 121, the process gas is split at the middle portion to flow towards two ends of the transition channel 122, so that the process gas is more evenly distributed inside the transition channel 122, thereby enhancing the uniformity of the process gas inside the corresponding spray channel 123, and finally improving the distribution uniformity of the process gas inside the processing chamber 200.

Specifically, the main gas inlet channel 121 is communicated with the transition channel 122 usually between two of the connecting channels 124. In the present embodiment, the numbers of the connecting channels 124 on two sides of the junction of the main gas inlet channel 121 and the transition channel 122 in the first direction are the same. For example, if the transition channel 122 is in communication with the corresponding spray channel 123 through four connecting channels 124, then two connecting channels 124 are distributed on each side of the junction of the main gas inlet channel 121 and the transition channel 122. As such, the process gas inside the transition channel 122 can enter the corresponding spray channel 123 more evenly.

Moreover, in the present embodiment, each of two ends of the main gas inlet channel 121 in an extension direction of the main gas inlet channel 121 is provided with a gas inlet. Therefore, when the process gas is introduced into the gas distribution system 120, two gas flows can be introduced from the two ends of the main gas inlet channel 121 to the multiple transition channels 122 simultaneously. In this way, the difference between flow rates of the gas at junctions of the main gas inlet channel 121 and the multiple transition channels 122 can be further reduced, and thus the gas pressure in the multiple transition channels 122 is more even, thereby further improving the distribution uniformity of the process gas inside the processing chamber 200.

To distribute the at least two gas distribution systems 120 in the plate body 110, the main gas inlet channel 121 is usually offset towards one side (i.e. not centrally arranged) in the width direction of the plate body 110. Specifically, in the present embodiment, the junction of the main gas inlet channel 121 and each of the multiple transition channels 122 is offset from the midpoint of the transition channel 122 towards one end of the transition channel 122.

In the present embodiment, the part of the transition channel 122 located on one side of the junction opposite to the midpoint has a smaller inner diameter than the part of the transition channel 122 located on the other side of the junction facing the midpoint. To facilitate describing, the two parts of the transition channel 122 on the two sides of the junction may be referred to as a first channel portion and a second channel portion respectively. A length of the first channel portion is smaller than a length of the second channel portion. In this way, the first channel portion is located on the one side of the junction opposite to the midpoint of the transition channel 122, and the second channel portion is located on the other side of the junction facing the midpoint of transition channel 122.

That is to say, the transition channel 122 has different inner diameters at different positions along the extension direction of the transition channel 122. In an example shown in FIG. 2, a junction of the main gas inlet channel 121 and each transition channel 122 of one gas distribution system 120 is offset to the left relative to the midpoint of the transition channel 122. That is, the inner diameter of the left part (i.e. the first channel portion) of the transition channel 122 is smaller than the inner diameter of the right part (i.e. the second channel portion) of the transition channel 122. More gas flows to the part having a larger inner diameter. As such, the process gas can be more evenly distributed inside the transition channel 122.

Apparently, in other embodiments, the junction of the main gas inlet channel 121 and each transition channel 122 may be at the midpoint of the transition channel 122 according to optimization of the arrangement.

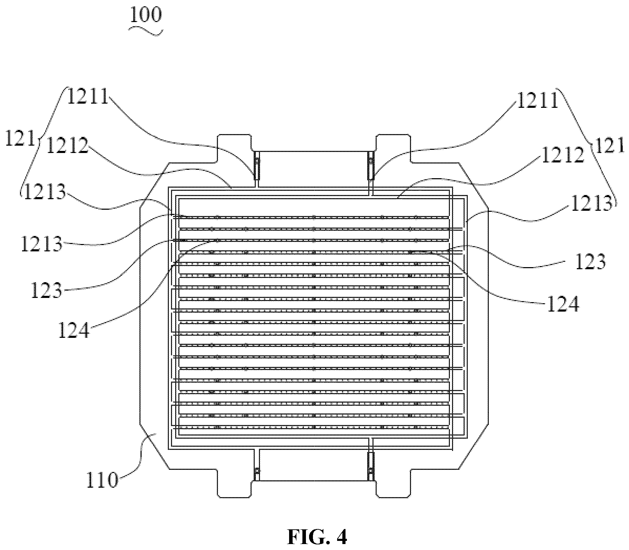

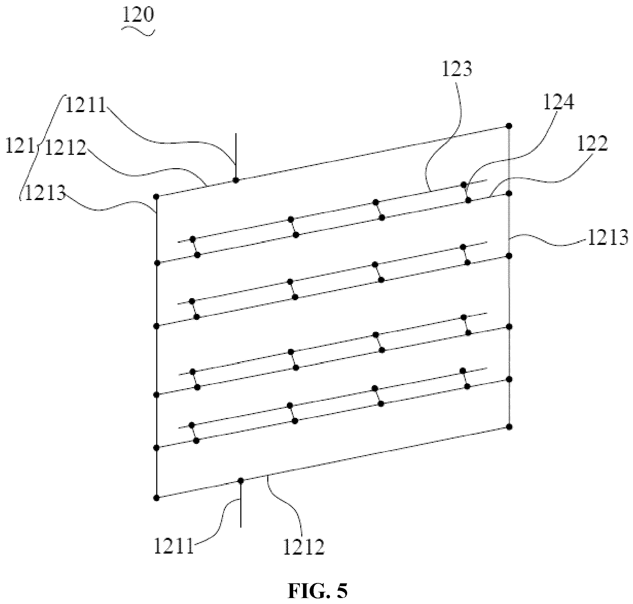

Referring to FIGS. 4 and 5, in another embodiment, the main gas inlet channel 121 includes an introducing channel 1211, a splitting channel 1212 and a discharging channel 1213.

The introducing channel 1211 is provided with a gas inlet, which can introduce the process gas. The splitting channel 1212 extends along the first direction, and the introducing channel 1211 is connected to a middle portion of the splitting channel 1212. The number of the discharging channel 1213 is two. The two discharging channels 1213 both extend along the second direction, and are in communication with two ends of the splitting channel 1212 respectively. One of the two discharging channels 1213 is in communication with one end of each of the multiple transition channels 122 in sequence, and the other one of the two discharging channels 1213 is in communication with the other end of each of the multiple transition channels 122 in sequence.

Specifically, the two discharging channels 1213 are respectively arranged on a left side and a right side of the plate body 110 (referring to the orientation and positional relationship in FIG. 4). The discharging channel 1213 on the left side is in communication with left ends of the multiple transition channel 122, and the discharging channel 1213 on the right side is in communication with right ends of the multiple transition channels 122. After being introduced through the introducing channel 1211, the process gas is split into two gas streams in the splitting channel 1212. The two gas streams respectively pass through the two discharging channels 1213 to enter each transition channel 122 through two ends of the transition channel 122. In this way, the uniformity of the process gas can be further improved.

In this embodiment, the numbers of the introducing channel 1211 and the splitting channel 1212 are both two. The two splitting channels 1212 are arranged at two ends of the plate body 110 in the second direction. One end of one of the two discharging channels 1213 and one end of the other one of the two discharging channels 1213 are in communication with two ends of one of the two splitting channels 1212 respectively, and the other end of the one of the two discharging channels 1213 and the other end of the other one of the two discharging channels 1213 are in communication with two ends of the other one of the two splitting channels 1212 respectively. In this way, process gas can be introduced into the gas distribution system 120 through the two introducing channels 1211 in two paths. Therefore, the difference between flow rates of the gas at the junctions of the main gas inlet channel 121 and the multiple transition channels 122 can be further reduced, and thus the gas pressure inside the multiple transition channels 122 is more even, thereby further improving the distribution uniformity of the process gas inside the processing chamber 200.

Similarly, to distribute the at least two gas distribution systems 120 in the plate body 110, each introducing channel 1211 is usually offset towards one side (i.e. not centrally arranged) in the width direction of the plate body 110. Specifically, in this embodiment, a junction of the introducing channel 1211 and the corresponding splitting channel 1212 is offset from the midpoint of the splitting channel 1212 towards one end of the splitting channel 1212.

In this embodiment, the part of the splitting channel 1212 located on one side of the junction opposite to the midpoint has a smaller inner diameter than the part of the splitting channel 1212 located on the other side of the junction facing the midpoint. To facilitate describing, the two parts of the splitting channel 1212 located on the two sides of the junction may be referred to as a third channel portion and a fourth channel portion respectively. A length of the third channel portion is smaller than a length of the fourth channel portion. In this way, the third channel portion is located on the one side of the junction opposite to the midpoint of the splitting channel 1212, and the fourth channel portion is located on the other side of the junction facing the midpoint of the splitting channel 1212.

That is to say, the splitting channel 1212 has different inner diameters at different positions along the extension direction of the splitting channel 1212. In an example shown in FIG. 4, a junction of each introducing channel 1211 and the corresponding splitting channel 1212 of one gas distribution system 120 is offset to the left relative to the midpoint of the splitting channel 1212, and the inner diameter of the left part (i.e. the third channel portion) of the splitting channel 1212 is smaller than the inner diameter of the right part (i.e. the fourth channel portion) of the splitting channel 1212. More gas flows to the part having a larger inner diameter. As such, the process gas can be more evenly distributed inside the splitting channel 1212, so that the two discharging channels 1213 can substantially receive the same flow quantity of process gas.

Apparently, in other embodiments, the junction of the introducing channel 1211 and the corresponding splitting channel 1212 may be at the midpoint of the splitting channel 1212 according to optimization to the arrangement.

According to the spray plate 100 and the processing device 10 mentioned above, the process gas enters an interior of the plate body 110 through the main gas inlet channel 121 firstly, then enters the spray channel 123 after being conveyed through the transition channel 122, and finally is introduced into the processing chamber 200 from the gas outlet face 111 through the spray holes 1231. The transition channel 122 can serve as a buffer to prevent the gas pressure inside the spray channel 123 from being directly affected by fluctuation of the gas pressure inside the main gas inlet channel 121, so that the gas pressure inside the spray channel 123 can keep good uniformity. Therefore, after being conveyed through the transition channels 122, the gas flow being sprayed from various regions of the gas outlet face 111 is more uniform, thereby improving the distribution uniformity of the process gas inside the processing chamber 200.

Moreover, a spray method is further provided according to the present application. The spray method can be carried out with the above spray plate 100 or with other spray devices.

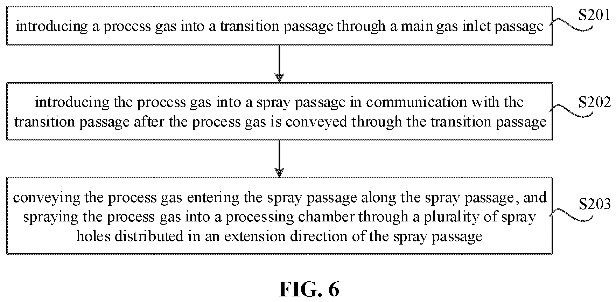

Referring to FIG. 6, the spray method according to an embodiment of the present application includes steps S201 to S203.

In step S201, a process gas is introduced into a transition channel through a main gas inlet channel.

In step S202, the process gas is conveyed through the transition channel and then introduced into a spray channel in communication with the transition channel.

In step S203, the process gas entering the spray channel is conveyed along the spray channel, and is sprayed into a processing chamber through multiple spray holes distributed in an extension direction of the spray channel.

The main gas inlet channel is provided with a gas inlet, which may be in communication with a gas source to introduce the process gas. The multiple spray holes are formed on the spray channel in the extension direction of the spray channel, and the spray channel is in communication with the main gas inlet channel through the transition channel. Therefore, the process gas being introduced into the plate body through the main gas inlet channel is conveyed through the transition channel, then is introduced into the spray channel, and finally is sprayed into the processing chamber through the spray holes. The transition channels can serve as a buffer to prevent a gas pressure inside the spray channel from being directly affected by fluctuation of a gas pressure inside the main gas inlet channel, so that the gas pressure inside the spray channel can keep good uniformity. Hence, the process gas can be sprayed from the spray holes at a relatively uniform flow speed, and the quantity of the gas flow is more even, thereby enhancing the distribution uniformity of the process gas inside the processing chamber.

The technical features in the above embodiments may be combined in any way. To make the description concise, not all possible combinations of the technical features in the above embodiments are described. However, all of these combinations of the technical features belong to the scope of this specification, as long as they do not contradict each other.

Only a few implementations of the present application are described in the above embodiments. The descriptions thereof are relatively specific and detailed, but they should not be construed as limitations to the scope of this application. It should be noted that, for those skilled in the art, a few of modifications and improvements may be made without departing from the concept of the present application, and these modifications and improvements are also deemed to fall into the protection scope of the present application. Therefore, the protection scope of the present application is defined by the attached claims.

## Claims

1. A spray plate, comprising a plate body that has a gas outlet face, wherein
a gas distribution system is formed in the plate body, and the gas distribution system comprises a main gas inlet channel, a transition channel and a spray channel; and
a plurality of spray holes are formed in the spray channel in an extension direction of the spray channel and extend to the gas outlet face, and the spray channel is in communication with the main gas inlet channel through the transition channel.

2. The spray plate according to claim 1, wherein
the gas distribution system comprises a plurality of the transition channels and a plurality of the spray channels, which are in one-to-one correspondence;
each spray channel is in communication with the corresponding transition channel through a plurality of connecting channels that are distributed at intervals in the extension direction of the spray channel; and
the main gas inlet channel is in communication with the plurality of transition channels in sequence.

3. The spray plate according to claim 2, wherein each spray channel is of an elongated shape and extends along a first direction, and the plurality of spray channels are arranged at intervals in a second direction perpendicular to the first direction.

4. The spray plate according to claim 3, wherein each transition channel is of an elongated shape, extends along the first direction, and is spaced apart from the corresponding spray channel in a third direction perpendicular to both of the first direction and the second direction.

5. The spray plate according to claim 3, wherein the main gas inlet channel is of an elongated shape and extends along the second direction.

6. The spray plate according to claim 5, wherein the main gas inlet channel is in communication with middle portions of the plurality of transition channels in sequence.

7. The spray plate according to claim 6, wherein a junction of the main gas inlet channel and each transition channel is offset from a midpoint of the transition channel towards an end of the transition channel.

8. The spray plate according to claim 7, wherein a part of the transition channel located on one side of the junction opposite to the midpoint has a smaller inner diameter than a part of the transition channel located on the other side of the junction facing the midpoint.

9. The spray plate according to claim 6, wherein a junction of the main gas inlet channel and each transition channel is at a midpoint of the transition channel.

10. The spray plate according to any one of claims 7 to 9, wherein the numbers of the connecting channels on two sides of the junction in the first direction are the same.

11. The spray plate according to claim 5, wherein each of two ends of the main gas inlet channel in an extension direction of the main gas inlet channel is provided with a gas inlet.

12. The spray plate according to claim 3, wherein
the main gas inlet channel comprises an introducing channel, a splitting channel that extends along the first direction, and two discharging channels that extend along the second direction, wherein
the introducing channel is in communication with a middle portion of the splitting channel, and the two discharging channels are in communication with two ends of the splitting channel respectively; and
one of the two discharging channels is in communication with one end of each of the transition channels in sequence, and the other one of the two discharging channels is in communication with the other end of each of the transition channels in sequence.

13. The spray plate according to claim 12, wherein a junction of the introducing channel and the splitting channel is offset from a midpoint of the splitting channel towards one end of the splitting channel.

14. The spray plate according to claim 13, wherein a part of the splitting channel located on one side of the junction opposite to the midpoint has a smaller inner diameter than a part of the splitting channel located on the other side of the junction facing the midpoint.

15. The spray plate according to claim 12, wherein a junction of the introducing channel and the splitting channel is at a midpoint of the splitting channel.

16. The spray plate according to claim 12, wherein
the numbers of the introducing channel and the splitting channel are both two;
the two splitting channels are respectively arranged at two ends of the plate body in the second direction; and
ends of the two introducing channels are in communication with two ends of one of the two splitting channels respectively, and the other ends of the two introducing channels are in communication with two ends of the other one of the two splitting channels respectively.

17. The spray plate according to claim 3, wherein at least two gas distribution systems are provided in the plate body, and have the spray channels alternately arranged in the second direction.

18. A spray plate, comprising a plate body that has a gas outlet face, wherein
a gas distribution system is formed in the plate body, and the gas distribution system comprises a main gas inlet channel, a transition channel and a spray channel;
the spray channel is in communication with a plurality of spray holes that are arranged at intervals in an extension direction of the spray channel; and
each of the plurality of spray holes extends to the gas outlet face, and the spray channel is in communication with the main gas inlet channel through the transition channel.

19. The spray plate according to claim 18, wherein
the gas distribution system comprises a plurality of the transition channels and a plurality of the spray channels, which are in one-to-one correspondence;
each spray channel is in communication with the corresponding transition channel through a plurality of connecting channels that are distributed at intervals in the extension direction of the spray channel; and
the main gas inlet channel is in communication with the plurality of transition channels in sequence.

20. The spray plate according to claim 19, wherein each spray channel is of an elongated shape and extends along a first direction, and the plurality of spray channels are arranged at intervals in a second direction being at an angle from the first direction.

21. The spray plate according to claim 20, wherein each transition channel is of an elongated shape, extends along the first direction, and is spaced apart from the corresponding spray channel in a third direction being at angles from the first direction and the second direction.

22. The spray plate according to claim 20, wherein the main gas inlet channel is of an elongated shape and extends along the second direction.

23. The spray plate according to claim 22, wherein a junction of the main gas inlet channel and each transition channel is offset from a midpoint of the transition channel towards an end of the transition channel.

24. The spray plate according to claim 23, wherein
the transition channel comprises a first channel portion and a second channel portion respectively located on two sides of the junction; and
a length of the first channel portion is smaller than a length of the second channel portion, and an inner diameter of the first channel portion is smaller than an inner diameter of the second channel portion.

25. The spray plate according to claim 22, wherein a junction of the main gas inlet channel and each transition channel is at a midpoint of the transition channel.

26. The spray plate according to any one of claims 23 to 25, wherein the numbers of the connecting channels on two sides of the junction of the transition channel in the first direction are the same.

27. The spray plate according to claim 22, wherein each of two ends of the main gas inlet channel in an extension direction of the main gas inlet channel is provided with a gas inlet.

28. The spray plate according to claim 20, wherein
the main gas inlet channel comprises an introducing channel, a splitting channel that extends along the first direction, and two discharging channels that extend along the second direction, wherein
the introducing channel is in communication with a middle portion of the splitting channel, and the two discharging channels are in communication with two ends of the splitting channel respectively; and
one of the two discharging channels is in communication with one end of each of the transition channels in sequence, and the other one of the two discharging channels is in communication with the other end of each of the transition channels in sequence.

29. The spray plate according to claim 28, wherein a junction of the introducing channel and the splitting channel is offset from a midpoint of the splitting channel towards one end of the splitting channel.

30. The spray plate according to claim 29, wherein
the splitting channel comprises a third channel portion and a fourth channel portion respectively located on two sides of the junction; and
a length of the third channel portion is smaller than a length of the fourth channel portion, and an inner diameter of the third channel portion is smaller than an inner diameter of the fourth channel portion.

31. The spray plate according to claim 28, wherein a junction of the introducing channel and the splitting channel is at a midpoint of the splitting channel.

32. The spray plate according to claim 28, wherein
the numbers of the discharging channels and the splitting channels are both two;
the two splitting channels are respectively arranged at two ends of the plate body in the second direction; and
ends of the two introducing channels are in communication with two ends of one of the two splitting channels respectively, and the other ends of the two introducing channels are in communication with two ends of the other one of the two splitting channels respectively.

33. The spray plate according to claim 20, wherein at least two gas distribution systems are provided in the plate body, and have the spray channels alternately arranged in the second direction.

34. A processing device, comprising the spray plate according to any one of claims 1 to 33 and a processing chamber, wherein the spray plate is mounted on the processing chamber, and the gas outlet face faces an inner side of the processing chamber.

35. A spray method, comprising the steps of:
introducing a process gas into a transition channel through a main gas inlet channel;
introducing the process gas through the transition channel into a spray channel in communication with the transition channel; and
conveying the process gas entering the spray channel along the spray channel, and spraying the process gas into a processing chamber through a plurality of spray holes distributed in an extension direction of the spray channel.
